# EUROPEAN PATENT APPLICATION

(11) **EP 4 624 967 A1**
(43) Date of publication of application: **01.10.2025**
(21) Application number: 25164839.0
(22) Date of filing: 19.03.2025
(51) Int. Cl.: G01R 31/74

(54) **FUSE MONITORING SYSTEM, METHOD AND APPARATUS, POWER DISTRIBUTION SYSTEM AND VEHICLE**

(30) Priority: 20.03.2024 CN 202410327441
(71) Applicant: BYD Company Limited, Shenzhen, Guangdong 518118 (CN)
(72) Inventor: LIU, Yushi, Shenzhen, 518118 (CN); XU, Feng, Shenzhen, 518118 (CN); BAI, Mengna, Shenzhen, 518118 (CN); FEI, Tianduo, Shenzhen, 518118 (CN); XU, Zhengyi, Shenzhen, 518118 (CN)
(74) Representative: Mathys & Squire

(57) **Abstract**

The present disclosure provides a fuse monitoring system, method and apparatus, a power distribution system and a vehicle. The fuse monitoring system includes: a current detection unit, the current detection unit being configured to detect a current current flowing through a target fuse; a voltage detection unit, the voltage detection unit being connected to the target fuse, and the voltage detection unit being configured to detect a current voltage at two ends of the target fuse; and an integrated control unit, the integrated control unit being connected to the current detection unit and the voltage detection unit, and the integrated control unit being configured to determine a health state of the target fuse based on the current current and the current voltage.

## Description

### FIELD

Embodiments of the present disclosure relate to the technical field of vehicles, and specifically, to a fuse monitoring system, a fuse monitoring method, a fuse monitoring apparatus, a power distribution system and a vehicle.

### BACKGROUND

With the rapid development of the new energy vehicle industry, fuses have been applied to more and more families because of the advantages of low carbon and environmental protection, low noise, high driving efficiency, and the like.

In a power distribution system of an electric vehicle, as the most important protective device, a fuse plays an irreplaceable role in protecting load and vehicle safety when short circuit and overload faults occur. The fuse on the electric vehicle needs to have fuse protection characteristics of a direct current fuse in an ordinary power distribution system, and further needs to withstand impact and vibration of road vehicles. In a current power distribution system of an electric vehicle, there is a lack of a monitoring system for a health state and lifespan of a fuse. The fuse can only be replaced passively after it has blown, and a fuse state cannot be determined, especially when an abnormal working condition occurs.

### SUMMARY

In view of the above defects or deficiencies in the related art, it is desirable to provide a fuse monitoring system, method and apparatus, a power distribution system and a vehicle.

According to a first aspect of the present disclosure, a fuse monitoring system is provided, including:
a current detection unit, the current detection unit being configured to detect a current current flowing through a target fuse;
a voltage detection unit, the voltage detection unit being connected to the target fuse, and the voltage detection unit being configured to detect a current voltage at two ends of the target fuse; and
an integrated control unit. The integrated control unit is connected to the current detection unit and the voltage detection unit, and the integrated control unit is configured to determine a health state of the target fuse based on the current current and the current voltage.

Optionally, the current detection unit includes:
a shunt, the shunt being connected to a power supply loop of the target fuse; and
a first optocoupler isolation and conditioning unit, an input end of the first optocoupler isolation and conditioning unit being connected to two ends of the shunt, and an output end of the first optocoupler isolation and conditioning unit being connected to the integrated control unit.

Optionally, the system further includes:
a temperature detection unit, the temperature detection unit being arranged in a first preset range close to the target fuse and is connected to the integrated control unit.

Optionally, the system further includes:
a communication unit, the communication unit being connected to the integrated control unit and being suitable for connection to an electronic control unit of a vehicle.

The communication unit is configured to acquire health state data of the target fuse sent by the integrated control unit and send the health state data to the electronic control unit.

Optionally, the voltage detection unit includes a second optocoupler isolation and conditioning unit.

An input end of the second optocoupler isolation and conditioning unit is connected to the two ends of the target fuse, and an output end of the second optocoupler isolation and conditioning unit is connected to the integrated control unit.

Optionally, the current detection unit includes:
a Hall current sensor, the Hall current sensor being arranged in a second preset range close to the target fuse; and
a third optocoupler isolation and conditioning unit. An input end of the third optocoupler isolation and conditioning unit is connected to the Hall current sensor, and an output end of the third optocoupler isolation and conditioning unit is connected to the integrated control unit.

According to a second aspect of the present disclosure, a fuse monitoring method is provided, including:
A current current flowing through a target fuse to be monitored and a current voltage at two ends of the target fuse are detected.

A health state of the target fuse is determined based on the current current and the current voltage.

Optionally, that a health state of the target fuse is determined based on the current current and the current voltage specifically includes:

A first resistance value of the target fuse is determined based on the current current and the current voltage.

A health state of the target fuse is determined based on the first resistance value.

Optionally, that a health state of the target fuse is determined based on the first resistance value includes:
A second resistance value of the target fuse is acquired. The second resistance value represents a cold resistance value of the target fuse.

A proportional coefficient between the first resistance value and the second resistance value is determined.

The health state of the target fuse is determined based on the proportional coefficient.

Optionally, the method further includes:
A remaining service life of the target fuse is determined based on the proportional coefficient when the proportional coefficient is greater than or equal to a first coefficient threshold.

Optionally, that a remaining service life of the target fuse is determined based on the proportional coefficient includes:

First mapping data reflecting a mapping relationship between the proportional coefficient and the remaining service life is acquired.

The remaining service life of the target fuse is obtained based on the proportional coefficient between the first resistance value and the second resistance value and the first mapping data.

Optionally, the method further includes:
A Joule integral of the target fuse is determined based on the current current when the current current is greater than or equal to a set current.

When the Joule integral is greater than or equal to a set value, the step that a health state of the target fuse is determined based on the current current and the current voltage is performed.

Optionally, the method further includes:
A current temperature of the target fuse is acquired.

A temperature coefficient corresponding to the current temperature is determined as a current temperature coefficient.

The first resistance value is corrected based on the current temperature coefficient.

Optionally, the method further includes:
A current temperature of the target fuse is acquired.

An abnormal operating duration of the target fuse is determined when the current temperature is greater than or equal to a set temperature. The abnormal operating duration is cumulative and continuous duration during which a temperature of the target fuse is greater than or equal to the set temperature.

The health state of the target fuse is monitored based on the abnormal operating duration.

According to a third aspect of the present disclosure, a fuse monitoring apparatus is provided, including a memory and a processor. The memory is configured to store a computer program, and the processor is configured to perform the method according to the second aspect of the present disclosure under the control of the computer program.

According to a fourth aspect of the present disclosure, a power distribution system is provided, including a fuse and the fuse monitoring system according to the first aspect of the present disclosure.

According to a fifth aspect of the present disclosure, a vehicle is provided, including the power distribution system according to the fourth aspect of the present disclosure.

In the embodiments of the present disclosure, the health state of the target fuse is monitored through the current voltage at the two ends of the target fuse and the current current flowing through the target fuse, so that obtained health state data of the target fuse can be more accurate.

Other features and advantages of the embodiments of the present disclosure become clear from the following detailed description of exemplary embodiments of the present disclosure with reference to accompanying drawings.

### BRIEF DESCRIPTION OF THE DRAWINGS

Accompanying drawings, which are incorporated in the specification and form a part of the specification, illustrate embodiments of the present disclosure and together with the descriptions thereof, are intended to explain the principles of the embodiments of the present disclosure.
FIG. 1 is a schematic structural diagram of a fuse monitoring system according to an embodiment of the present disclosure;
FIG. 2 is a schematic structural diagram of a fuse monitoring system according to an embodiment of the present disclosure;
FIG. 3 is a schematic structural diagram of a fuse monitoring system according to an embodiment of the present disclosure;
FIG. 4 is a diagram illustrating a circuit principle of an isolation amplifier circuit according to an embodiment of the present disclosure;
FIG. 5 is a schematic structural diagram of a power distribution system according to an embodiment of the present disclosure;
FIG. 6 is a schematic flowchart of a fuse monitoring method according to an embodiment of the present disclosure;
FIG. 7 is a schematic flowchart of an example of a fuse monitoring method according to an embodiment of the present disclosure; and
FIG. 8 is a schematic structural diagram of a fuse monitoring apparatus according to an embodiment of the present disclosure.

### DETAILED DESCRIPTION

Various exemplary embodiments of the present disclosure are now described in detail with reference to the accompanying drawings. It should be noted that unless otherwise specified, relative arrangement, numerical expressions and numerical values of components and steps set forth in the embodiments do not limit the scope of the present disclosure.

The following descriptions of at least one exemplary embodiment are merely illustrative in nature, and in no way constitute any limitation on the present disclosure and application or use thereof.

Technologies, methods and devices known to a person of ordinary skill in the related art may not be discussed in detail, but where appropriate, the technologies, the methods and the devices should be considered as a part of the specification.

In all examples shown and discussed herein, any specific value should be interpreted as illustrative only rather than restrictive. Therefore, other examples of exemplary embodiments may have different values.

It should be noted that similar reference signs and letters indicate similar items in the following accompanying drawings. Therefore, once an item is defined in one accompanying drawing, the item does not need to be further discussed in subsequent accompanying drawings.

It can be understood that with the raising of environmental protection awareness and the continuous development of the automobile market, new energy vehicles have gradually become the mainstream of the market.

In a power distribution system of an electric vehicle, as the most important protective device, a fuse plays an irreplaceable role in protecting load and vehicle safety when short circuit and overload faults occur. The fuse on the electric vehicle needs to have fuse protection characteristics of a direct current fuse in an ordinary power distribution system, and further needs to withstand impact and vibration of road vehicles. In a current power distribution system of an electric vehicle, there is a lack of a monitoring system for a health state and lifespan of a fuse. The fuse can only be replaced passively after it has blown, and a fuse state cannot be determined especially when an abnormal working condition occurs.

Two-stage or three-stage fuse protection is mostly provided in power distribution systems of electric vehicles, so as to ensure that during the vehicle's power consumption, when any load fails, which causes a lower-stage fuse to blow, an upper-stage power supply and other lower-stage power supplies are not affected. When the lower-stage fuse blows, an upper-stage fuse bears a small rate current impact, and it is impossible to determine whether the upper-stage fuse can normally play a protective role.

Since there are various electrical devices in a vehicle, including a resistive load, an inductive load and a capacitive load, current surge occurs at a moment when an electrical device is started, and repeated startups can inevitably affect a fuse's functionality and may lead to a premature fusing fault.

When the vehicle runs in a high-temperature area for a long time, there is a high ambient temperature in the vehicle cabin, which may also affect the overload characteristics of the fuse.

In view of the above defects, the present disclosure provides a fuse monitoring system, method and apparatus, a power distribution system and a vehicle, which, compared with the related art, monitor a health state of a target fuse through a current voltage at two ends of the target fuse and a current current flowing through the target fuse, so that a health state monitoring result of the target fuse can be more accurately obtained.

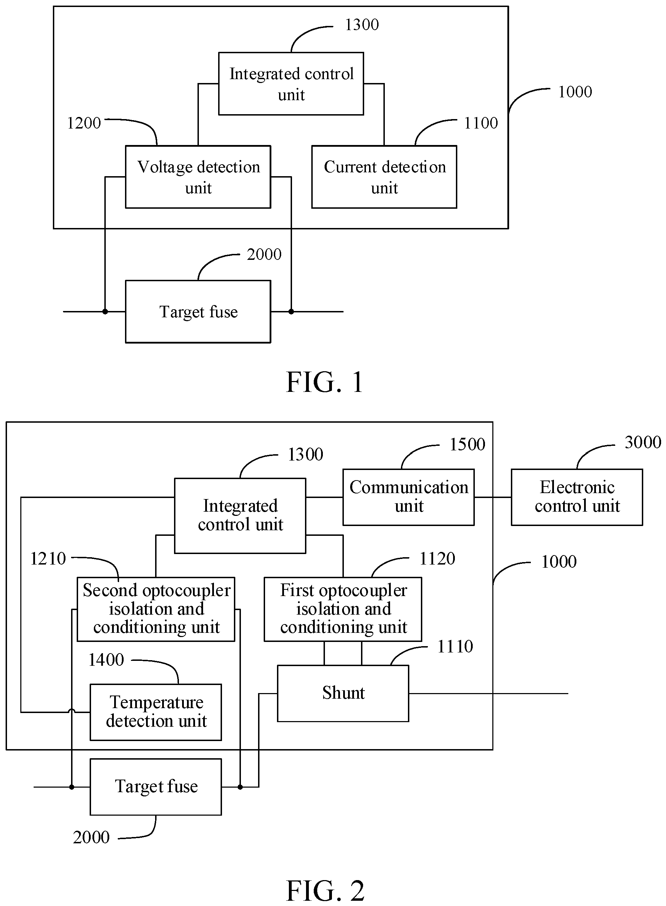

FIG. 1 is a schematic structural diagram of a fuse monitoring system according to an embodiment of the present disclosure. As shown in FIG. 1, a fuse monitoring system 1000 includes a current detection unit 1100, a voltage detection unit 1200 and an integrated control unit 1300.

The current detection unit 1100 is configured to detect a current current flowing through a target fuse 2000 to be monitored.

The voltage detection unit 1200 is connected to the target fuse 2000, and the voltage detection unit 1200 is configured to detect a current voltage at two ends of the target fuse 2000.

The integrated control unit 1300 is connected to the current detection unit 1100 and the voltage detection unit 1200, and the integrated control unit 1300 is configured to acquire the current current and the current voltage, and monitor a health state of the target fuse 2000 based on the current current and the current voltage.

In some embodiments, as shown in FIG. 2, the current detection unit 1100 may include a shunt 1110 and a first optocoupler isolation and conditioning unit 1120. The shunt 1110 is connected to a power supply loop of the target fuse 2000. An input end of the first optocoupler isolation and conditioning unit 1120 is connected to two ends of the shunt 1110, and an output end of the first optocoupler isolation and conditioning unit 1120 is connected to the integrated control unit 1300.

The shunt is a device configured to measure a direct current, which is manufactured based on a principle that a voltage is generated at two ends of a resistor when the direct current passes through the resistor. For example, the shunt may be a resistor with a set resistance value.

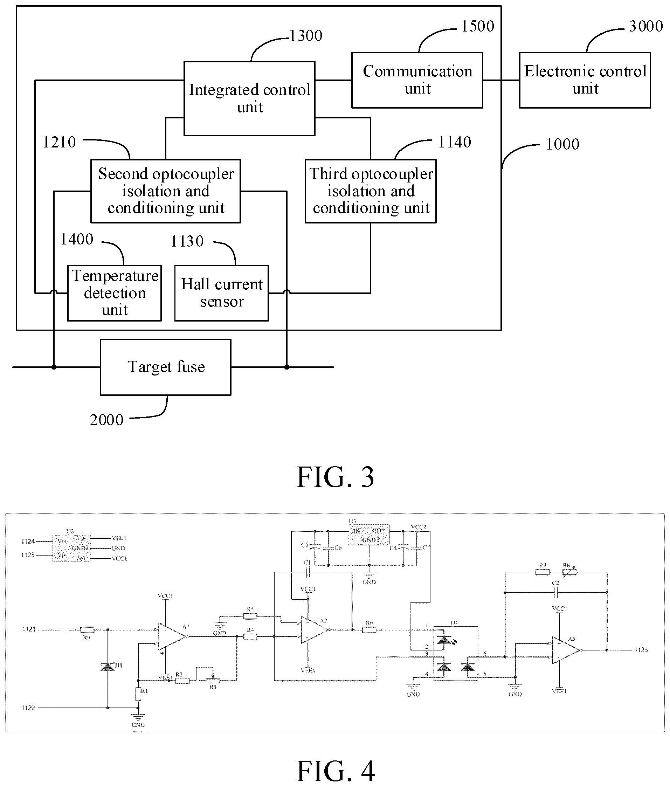

In some other embodiments, as shown in FIG. 3, the current detection unit 1100 may include a Hall current sensor 1130 and a third optocoupler isolation and conditioning unit 1140. The Hall current sensor 1130 is arranged in a second preset range close to the target fuse 2000. An input end of the third optocoupler isolation and conditioning unit 1140 is connected to the Hall current sensor 1130, and an output end of the third optocoupler isolation and conditioning unit 1140 is connected to the integrated control unit 1300.

The second preset range may be preset based on a sensing range of the Hall current sensor.

The Hall current sensor is manufactured based on a principle of Hall effect, and implements, through electromagnetic induction, non-contact detection of the current flowing through the target fuse 2000. The Hall current sensor can be any type of Hall current sensor, which may not be limited by a sampling frequency, and can accurately identify a current impact with a pulse width less than the sampling frequency. To avoid modifying a power supply line where the target fuse 2000 is located, a planar Hall current sensor can be used, and the planar Hall current sensor only needs to be arranged on the target fuse 2000 without modifying the power supply line where the target fuse 2000 is located, which is easier to implement.

In this embodiment, the current detection unit 1100 can detect the current current, and output a second voltage signal denoting the current current to the integrated control unit 1300.

In the embodiment of the present disclosure, the health state of the target fuse is monitored through the current voltage at the two ends of the target fuse and the current current flowing through the target fuse, so that the obtained health state monitoring result of the target fuse can be more accurate.

In some embodiments, the voltage detection unit 1200 may have a first input terminal, a second input terminal and an output terminal. The first input terminal and the second input terminal are connected to the two ends of the target fuse 2000 respectively, and the output terminal is connected to the integrated control unit 1300. The voltage detection unit 1200 can detect the current voltage, and output a first voltage signal denoting the current voltage to the integrated control unit 1300.

In an embodiment of the present disclosure, as shown in FIGS. 2 and 3, the voltage detection unit 1200 includes a second optocoupler isolation and conditioning unit 1210. An input end of the second optocoupler isolation and conditioning unit 1210 is connected to the two ends of the target fuse 2000, and an output end of the second optocoupler isolation and conditioning unit 1210 is connected to the integrated control unit 1300.

In an embodiment of the present disclosure, any one of the first optocoupler isolation and conditioning unit 1120, the second optocoupler isolation and conditioning unit 1210 and the third optocoupler isolation and conditioning unit 1140 is configured to perform isolation and amplification processing on an input voltage signal.

In some embodiments, as shown in FIG. 4, any optocoupler isolation and conditioning unit may include a first input terminal 1121, a second input terminal 1122, an output terminal 1123, a first operational amplifier A1 and a photocoupler U1.

When the optocoupler isolation and conditioning unit is the first optocoupler isolation and conditioning unit 1120, the first input terminal 1121 is configured to connect one of the two ends of the shunt 1110 with a higher level, and the second input terminal 1122 is configured to connect one of the two ends of the shunt 1110 with a lower level. When the optocoupler isolation and conditioning unit is the second optocoupler isolation and conditioning unit 1210, the first input terminal 1121 is configured to connect one of the two ends of the target fuse 2000 with a higher level, and the second input terminal 1122 is configured to connect one of the two ends of the target fuse 2000 with a lower level. When the optocoupler isolation and conditioning unit is the third optocoupler isolation and conditioning unit 1140, the first input terminal 1121 is configured to connect an output terminal of the Hall current sensor 1130, and the second input terminal 1122 is configured to connect a ground terminal of the fuse monitoring system.

As shown in FIG. 4, the first input terminal 1121 is connected to a non-inverting input terminal of the first operational amplifier A1, and the second input terminal 1122 is connected to an inverting input terminal of the first operational amplifier A1. An output terminal of the first operational amplifier A1 is connected to a first pin 1 of the photocoupler U1, and the first pin 1 corresponds to an anode of a light-emitting diode in the photocoupler U1. A fifth pin 5 of the photocoupler U1 is connected to a ground terminal GND, and a sixth pin 6 of the photocoupler U1 is connected to the output terminal 1123. The fifth pin 5 corresponds to an anode of a first photosensitive diode in the photocoupler U1, and the sixth pin 6 corresponds to a cathode of the first photosensitive diode in the photocoupler U1.

As shown in FIG. 4, the optocoupler isolation and conditioning unit may further include a zener diode D1. An anode of the zener diode D1 is connected to the second input terminal 1122, and a cathode of the zener diode D1 is connected to the first input terminal 1121.

As shown in FIG. 4, the optocoupler isolation and conditioning unit may further include a second operational amplifier A2. An inverting input terminal of the second operational amplifier A2 may be connected to the output terminal of the first operational amplifier A1, and a non-inverting input terminal of the second operational amplifier A2 is connected to a ground terminal GND. An output terminal of the second operational amplifier A2 is connected to the first pin 1 of the photocoupler U1. The inverting input terminal of the second operational amplifier A2 is further connected to a third pin 3 of the photocoupler U1, and a fourth pin 4 of the photocoupler U1 is connected to a ground terminal GND. The third pin 3 corresponds to a cathode of a second photosensitive diode in the photocoupler U1, and the fourth pin 4 corresponds to an anode of the second photosensitive diode in the photocoupler U1.

As shown in FIG. 4, the optocoupler isolation and conditioning unit may further include a third operational amplifier A3. A non-inverting input terminal of the third operational amplifier A3 is connected to a ground terminal GND, and an inverting input terminal of the third operational amplifier A3 is connected to the sixth pin 6 of the photocoupler U1. An output terminal of the third operational amplifier A3 is connected to the output terminal 1123.

As shown in FIG. 4, the optocoupler isolation and conditioning unit may further include a positive electrode power supply terminal 1124, a negative electrode power supply terminal 1125, a DC-DC converter U2 and a linear voltage regulator U3. The positive electrode power supply terminal 1124 is configured to be connected to a positive electrode of a vehicle battery, and the negative electrode power supply terminal 1125 is configured to be connected to a negative electrode of the vehicle battery. The positive electrode power supply terminal 1124 is connected to a positive electrode input terminal Vi+ of the DC-DC converter U2, and the negative electrode power supply terminal 1125 is connected to a negative electrode input terminal Vi- of the DC-DC converter U2. A positive output terminal Vo+ of the DC-DC converter U2 provides a positive voltage VCC1 for each operational amplifier, and a negative output terminal Vo- of the DC-DC converter U2 provides a negative voltage VEE1 for each operational amplifier. An input terminal IN of the linear voltage regulator U3 is connected to the positive output terminal Vo+ of the DC-DC converter U2, and an output terminal OUT of the linear voltage regulator U3 is connected to a second pin 2 of the photocoupler U1. The second pin 2 corresponds to a cathode of the light-emitting diode in the photocoupler U1.

As shown in FIG. 4, the optocoupler isolation and conditioning unit may further include at least one of a first resistor R1, a second resistor R2, a third resistor R3, a fourth resistor R4, a fifth resistor R5, a sixth resistor R6, a seventh resistor R7, an eighth resistor R8 and a ninth resistor R9. The first resistor is connected between the inverting input terminal of the first operational amplifier A1 and the second input terminal 1122. The second resistor R2 and the third resistor R3 are connected in series between the output terminal of the first operational amplifier A1 and the inverting input terminal of the first operational amplifier A1. The fourth resistor R4 is connected between the output terminal of the first operational amplifier A1 and the inverting input terminal of the second operational amplifier A2. The fifth resistor R5 is connected between the non-inverting input terminal of the second operational amplifier A2 and a ground terminal GND. The sixth resistor R6 is connected between the output terminal of the second operational amplifier A2 and the first pin 1 of the photocoupler U1. The seventh resistor R7 and the eighth resistor R8 are connected between the inverting input terminal and the output terminal of the third operational amplifier A3. The ninth resistor R9 is connected between the non-inverting input terminal of the first operational amplifier A1 and the first input terminal 1121.

As shown in FIG. 4, the optocoupler isolation and conditioning unit may further include at least one of a first capacitor C1, a second capacitor C2, a third capacitor C3, a fourth capacitor C4, a fifth capacitor C5 and a sixth capacitor C6. The first capacitor C1 is connected between the inverting input terminal of the first operational amplifier A1 and the output terminal of the first operational amplifier A1. The second capacitor C2 is connected between the inverting input terminal of the third operational amplifier A3 and the output terminal of the third operational amplifier A3. The third capacitor C3 and the fourth capacitor C4 are connected in parallel between the output terminal OUT of the linear voltage regulator U3 and a ground terminal GND. The fifth capacitor C5 and the sixth capacitor C6 are connected in parallel between the input terminal IN of the linear voltage regulator U3 and the ground terminal GND.

In this embodiment, the photocoupler U1 includes a high-performance light-emitting diode and two adjacent matched photosensitive diodes. The two photosensitive diodes have the same performance parameters. The light-emitting diode is an input terminal of an isolated signal, and may emit light when a current flows therethrough. The two photosensitive diodes may generate a photocurrent when light is irradiated. An internal packaging structure enables the two photosensitive diodes to obtain approximate illumination from the light-emitting diode and induce the photocurrent proportional to a luminous intensity, thereby implementing current isolation between input and output circuits. An isolated voltage signal is processed by the third operational amplifier A3 to improve stability and linearity of the isolated signal.

In the optocoupler isolation and conditioning unit, the first resistor R1 achieve a current limiting effect. The third resistor R3 is configured to control the luminous intensity of the light-emitting diode in the photocoupler U1, thereby playing a certain role in controlling a channel gain. The first operational amplifier A1 and the second operational amplifier A2 enhance a load driving capability. The first capacitor C1 plays a feedback role, stabilizes an output of the first operational amplifier A1, and can filter out a glitch signal in the circuit. The second capacitor C2 can suppress high-frequency noise generated by the photocoupler U1.

The voltage detection unit 1200 in this embodiment is provided by the second optocoupler isolation and conditioning unit. The current detection unit 1100 includes the first optocoupler isolation and conditioning unit or the third optocoupler isolation and conditioning unit, which can effectively isolate a high-voltage line where the target fuse is located from a low-voltage line and a weak-current line of the fuse monitoring system, prevent adverse effects such as interference, and ensure electrical safety of the weak-current line.

In this embodiment, a resistance value of the fuse is an important parameter for determining a health state of the fuse.

In an embodiment of the present disclosure, the current current and the current voltage may correspond to the same time. The integrated control unit 1300 may determine a first resistance value of the target fuse based on the current voltage and the current current, and determine a health state of the target fuse based on the first resistance value.

Specifically, the integrated control unit 1300 may determine a ratio obtained by dividing the current voltage by the current current as the first resistance value.

In an embodiment of the present disclosure, as shown in FIGS. 2 and 3, the fuse monitoring system 1000 further includes a temperature detection unit 1400.

The temperature detection unit 1400 is arranged in a first preset range close to the target fuse 2000 and is connected to the integrated control unit 1300. The first preset range may be set based on a detection range of the temperature detection unit 1400.

The temperature detection unit 1400 is configured to detect a current temperature of the target fuse 2000.

The integrated control unit 1300 is configured to acquire the current temperature, determine a temperature coefficient corresponding to the current temperature as a current temperature coefficient, and correct the first resistance value based on the current temperature coefficient.

In some embodiments, the temperature detection unit 1400 is in contact with a contact of the target fuse 2000 to detect a current temperature of the contact of the target fuse 2000.

In some embodiments, second mapping data reflecting a mapping relationship between a temperature and a temperature coefficient may be preset; and a temperature coefficient corresponding to the current temperature is obtained based on the current temperature and the second mapping data as a current temperature coefficient.

The second mapping data may be a second mapping function, a second comparison table, or the like, which is not limited herein.

With regard to the second mapping function, a dependent variable of the second mapping function is the temperature coefficient and an independent variable thereof is the temperature, so that the current temperature coefficient corresponding to the current temperature can be obtained by substituting the current temperature into the second mapping function.

With regard to the second comparison table, the current temperature coefficient corresponding to the current temperature can be found in the second comparison table. If the current temperature cannot be directly found in the second comparison table, two values adjacent to the current temperature can be found, and the current temperature coefficient corresponding to the current temperature can be obtained by interpolation based on the two values and temperature coefficients corresponding to the two values respectively.

In some embodiments, multiple temperature ranges and a temperature coefficient corresponding to each temperature range may alternatively be preset. Then, the temperature coefficient corresponding to the temperature range where the current temperature is located can be determined as the current temperature coefficient.

In some embodiments, the first resistance value is corrected based on the current temperature coefficient, which may be by multiplying the current temperature coefficient by the first resistance value.

In this embodiment, the first resistance value is corrected based on the current temperature coefficient, so that health state data of the target fuse 2000 subsequently obtained based on the first resistance value can be more accurate.

In an embodiment of the present disclosure, the integrated control unit 1300 is configured to determine an abnormal operating duration of the target fuse 2000 when the current temperature is greater than or equal to a set temperature, the abnormal operating duration being cumulative and continuous duration during which a temperature of the target fuse 2000 is greater than or equal to the set temperature, and monitor the health state of the target fuse 2000 based on the abnormal operating duration.

It can be understood that the set temperature may be preset based on an application scenario or a specific requirement. For example, the set temperature may be 100°C.

In this embodiment, to determine the abnormal operating duration of the target fuse 2000, the abnormal operating duration can be cleared to zero when the current temperature is less than the set value.

In some embodiments, the integrated control unit 1300 can determine that the health state of the target fuse 2000 is abnormal when the abnormal operating duration is greater than or equal to set duration, or determine that the health state of the target fuse 2000 is normal when the abnormal operating duration is less than the set duration. The set duration may be preset based on an application scenario or a specific requirement. For example, the set duration may be 20 minutes.

In this embodiment, the health state of the target fuse is monitored based on the abnormal operating duration, which can increase the determining basis of the health state and improve accuracy of the obtained health state data.

In some embodiments, the integrated control unit 1300 is configured to compare the first resistance value with a set resistance value, and determine that the health state of the target fuse 2000 is abnormal when the first resistance value is greater than or equal to the set resistance value, or determine that the health state of the target fuse 2000 is normal when the first resistance value is less than the set resistance value. The set resistance value may be preset based on an application scenario or a specific requirement.

In some embodiments, the integrated control unit 1300 is configured to acquire a cold resistance value of the target fuse 2000, determine a proportional coefficient between the first resistance value and the cold resistance value, and monitor the health state of the target fuse 2000 based on the proportional coefficient.

In an example, the cold resistance value may be a resistance value of the target fuse 2000 when there is no current, that is, at room temperature, and generally means a resistance value at 25°C.

In another example, when a vehicle is started for the first time, an initial current flowing through the target fuse can be acquired by the current detection unit 1100, and an initial voltage at two ends of the target fuse can be detected by the voltage detection unit 1200. When the initial current is less than or equal to a set current, a ratio of the initial voltage to the initial current can be determined as the cold resistance value.

Further, the integrated control unit 1300 can determine that the health state of the target fuse 2000 is abnormal when the proportional coefficient is greater than or equal to a first coefficient threshold, or determine that the health state of the target fuse 2000 is normal when the proportional coefficient is less than the first coefficient threshold. The first coefficient threshold may be preset based on an application scenario or a specific requirement. For example, the first coefficient threshold is 1.5.

In an embodiment of the present disclosure, when the health state of the target fuse 2000 is abnormal, the integrated control unit 1300 is further configured to determine a remaining service life of the target fuse 2000 based on the proportional coefficient.

In an embodiment, that a remaining service life of the target fuse 2000 is determined based on the proportional coefficient may include: First mapping data reflecting a mapping relationship between the proportional coefficient and the remaining service life is acquired. The remaining service life of the target fuse 2000 is obtained based on the proportional coefficient between the first resistance value and the cold resistance value and the first mapping data.

The first mapping data may be a first mapping function, a first comparison table, or the like, which is not limited herein.

With regard to the first mapping function, a dependent variable of the first mapping function is the remaining service life and an independent variable thereof is the proportional coefficient, so that the remaining service life corresponding to the proportional coefficient can be obtained by substituting the proportional coefficient between the first resistance value and the cold resistance value into the first mapping function.

With regard to the first comparison table, the remaining service life corresponding to the proportional coefficient between the first resistance value and the cold resistance value can be found in the first comparison table. If the proportional coefficient cannot be directly found in the first comparison table, two values adjacent to the proportional coefficient can be found, and the remaining service life corresponding to the proportional coefficient can be obtained by interpolation based on the two values and remaining service lives corresponding to the two values respectively.

In an embodiment, the integrated control unit 1300 can predetermine the remaining service life of the target fuse 2000 based on a user's driving habits and the proportional coefficient. The remaining service life can be expressed as a number of times that the user can perform extreme working conditions such as rapid acceleration.

In an embodiment of the present disclosure, the integrated control unit 1300 is configured to determine the first resistance value of the target fuse 2000 each time the vehicle is powered on, and monitor the health state of the target fuse 2000 based on the first resistance value.

In another embodiment of the present disclosure, the integrated control unit 1300 is configured to determine the first resistance value of the target fuse 2000 when a set time is reached, and monitor the health state of the target fuse 2000 based on the first resistance value. The set time may be preset based on an application scenario or a specific requirement.

In an embodiment of the present disclosure, the integrated control unit 1300 is configured to determine a Joule integral of the target fuse 2000 based on the current current when the current current is greater than or equal to the set current, and determine the first resistance value of the target fuse 2000 when the Joule integral is greater than or equal to a set value.

In this embodiment, the integrated control unit 1300 can sample, at a set frequency, a continuous current detected by the current detection unit 1100, to obtain multiple discrete currents. During current detection by the current detection unit 1100, when a latest obtained current current is greater than or equal to the set current, a square value of the current current is discretely integrated to obtain the Joule integral of the target fuse 2000. When the Joule integral of the target fuse 2000 is accumulated to be greater than or equal to the set value, the health state of the target fuse 2000 is determined through the aforementioned embodiment.

When no Joule integral of the target fuse 2000 is accumulated to be greater than or equal to the set value, the health state of the target fuse is usually normal, and therefore may not be monitored, thereby saving computing power of the integrated control unit.

In an embodiment of the present disclosure, as shown in FIGS. 2 and 3, the fuse monitoring system 1000 further includes a communication unit 1500. The communication unit 1500 is connected to the integrated control unit 1300, and the communication unit 1500 is configured to be connected to the integrated control unit 1300 and an electronic control unit 3000 of the vehicle.

In an example, the communication unit 1500 may be connected to the electronic control unit 3000 of the vehicle via a controller area network (CAN).

The integrated control unit 1300 is configured to send the health state data of the target fuse 2000 to the electronic control unit 3000 through the communication unit 1500.

In this embodiment, the health state data of the target fuse 2000 may include at least one of the following: a result that the health state of the target fuse is normal or abnormal, the proportional coefficient, the remaining service life, the Joule integral and the first resistance value.

In an example, the electronic control unit 3000 may send a life early-warning to a background server or make an abnormality reminder through a dashboard of the vehicle when the health state of the target fuse is abnormal.

In an example, the electronic control unit 3000 may send a life pre-warning to the background server when the proportional coefficient is greater than or equal to a second coefficient threshold. The second coefficient threshold may be preset based on an application scenario or a specific requirement. For example, the second coefficient threshold may be 2.

In an example, the electronic control unit 3000 can control the dashboard of the vehicle to display the health state data of the target fuse 2000.

In an example, the electronic control unit 3000 can determine the remaining service life based on the proportional coefficient and the user's driving habits.

Through this embodiment, the user can be reminded to replace the target fuse in time, so as to prevent the user from driving under extreme working conditions such as rapid acceleration when a target fuse fault occurs, which otherwise affects the user's safety, thereby ensuring the user's driving safety.

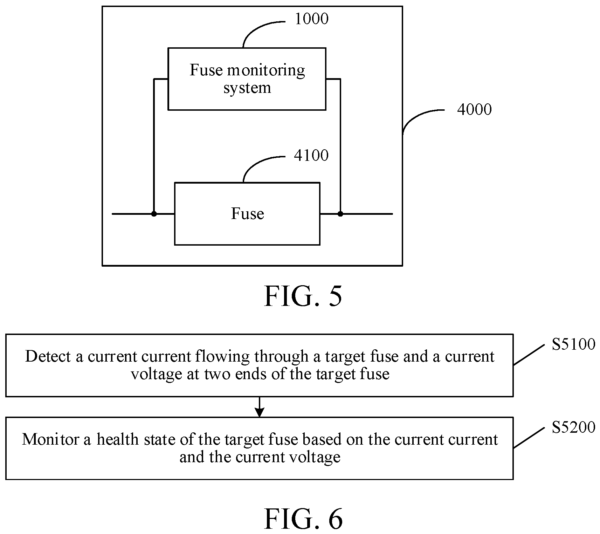

This embodiment further provides a power distribution system. As shown in FIG. 5, this power distribution system 4000 includes a fuse 4100 and the fuse monitoring system 1000 as described in the aforementioned embodiment.

The power distribution system according to this embodiment may be a high-voltage power distribution system or a low-voltage power distribution system. Specifically, the fuse may be connected to a power supply loop of a power battery of a vehicle or to a power supply loop of a starting battery of the vehicle.

Further, multiple fuses and fuse monitoring systems 1000 in a one-to-one correspondence with the fuses may be provided in the power distribution system. Each fuse monitoring system 1000 may be configured to monitor the health state of the corresponding fuse.

This embodiment further provides a fuse monitoring method. As shown in FIG. 6, the method may include the following steps S5100 and S5200:

S5100: A current current flowing through a target fuse to be monitored and a current voltage at two ends of the target fuse are detected.

In this embodiment, a target current can be detected by the current detection unit 1100 in the aforementioned embodiment, and a target voltage can be detected by the voltage detection unit 1200 in the aforementioned embodiment.

Step S5200: A health state of the target fuse is monitored based on the current current and the current voltage.

In an embodiment of the present disclosure, that a health state of the target fuse is monitored based on the current current and the current voltage may include: A first resistance value of the target fuse is determined based on the current current and the current voltage. The health state of the target fuse is monitored based on the first resistance value.

In an embodiment, a ratio obtained by dividing the current voltage by the current current may be determined as the first resistance value.

In another embodiment, the method may further include: A current temperature of the target fuse is acquired. A temperature coefficient corresponding to the current temperature is determined as a current temperature coefficient. The first resistance value is corrected based on the current temperature coefficient.

The current temperature may be detected by a temperature detection unit arranged in a first preset range close to the target fuse.

In some embodiments, second mapping data reflecting a mapping relationship between a temperature and a temperature coefficient may be preset; and a temperature coefficient corresponding to the current temperature is obtained based on the current temperature and the second mapping data as a current temperature coefficient.

The second mapping data may be a second mapping function, a second comparison table, or the like, which is not limited herein.

With regard to the second mapping function, a dependent variable of the second mapping function is the temperature coefficient and an independent variable thereof is the temperature, so that the current temperature coefficient corresponding to the current temperature can be obtained by substituting the current temperature into the second mapping function.

With regard to the second comparison table, the current temperature coefficient corresponding to the current temperature can be found in the second comparison table. If the current temperature cannot be directly found in the second comparison table, two values adjacent to the current temperature can be found, and the current temperature coefficient corresponding to the current temperature can be obtained by interpolation based on the two values and temperature coefficients corresponding to the two values respectively.

In some embodiments, multiple temperature ranges and a temperature coefficient corresponding to each temperature range may alternatively be preset. Then, the temperature coefficient corresponding to the temperature range where the current temperature is located can be determined as the current temperature coefficient.

In some embodiments, the first resistance value is corrected based on the current temperature coefficient, which may be by multiplying the current temperature coefficient by the first resistance value.

In an embodiment, the first resistance value of the target fuse can be determined each time a vehicle is powered on, and the health state of the target fuse is monitored based on the first resistance value.

In an embodiment, the first resistance value of the target fuse can be determined when a set time is reached, and the health state of the target fuse is monitored based on the first resistance value. The set time may be preset based on an application scenario or a specific requirement.

In an embodiment, before performing of step S5200, the method may further include: A Joule integral of the target fuse is determined based on the current current when the current current is greater than or equal to a set current. The health state of the target fuse is determined when the Joule integral is greater than or equal to a set value.

In this embodiment, a continuous current detected by the current detection unit can be sampled at a set frequency, to obtain multiple discrete currents. During current detection by the current detection unit, when a latest obtained current current is greater than or equal to the set current, a square value of the current current is discretely integrated to obtain the Joule integral of the target fuse. When the Joule integral of the target fuse is accumulated to be greater than or equal to the set value, the first resistance value of the target fuse is determined through the aforementioned embodiment.

When no Joule integral of the target fuse is accumulated to be greater than or equal to the set value, the health state of the target fuse is usually normal, and therefore may not be monitored, thereby saving computing power of the integrated control unit.

In an embodiment of the present disclosure, that the health state of the target fuse is monitored based on the first resistance value may include: It is determined that the health state of the target fuse is abnormal when the first resistance value is greater than or equal to the set resistance value, or it is determined that the health state of the target fuse is normal when the first resistance value is less than the set resistance value. The set resistance value may be preset based on an application scenario or a specific requirement.

In another embodiment of the present disclosure, that the health state of the target fuse is monitored based on the first resistance value includes: A cold resistance value of the target fuse is acquired. A proportional coefficient between the first resistance value and the cold resistance value is determined. The health state of the target fuse is monitored based on the proportional coefficient.

In an example, the cold resistance value may be a resistance value of the target fuse 2000 when there is no current, that is, at room temperature, and generally means a resistance value at 25°C.

In another example, when a vehicle is started for the first time, an initial current flowing through the target fuse can be acquired by the current detection unit, and an initial voltage at two ends of the target fuse can be detected by the voltage detection unit. When the initial current is less than or equal to a set current, a ratio of the initial voltage to the initial current can be determined as the cold resistance value.

Further, it can be determined that the health state of the target fuse is abnormal when the proportional coefficient is greater than or equal to a first coefficient threshold, or it can be determined that the health state of the target fuse is normal when the proportional coefficient is less than the first coefficient threshold. The first coefficient threshold may be preset based on an application scenario or a specific requirement. For example, the first coefficient threshold is 1.5.

In an embodiment of the present disclosure, the method may further include: An abnormal operating duration of the target fuse is determined when the current temperature is greater than or equal to a set temperature. The abnormal operating duration is cumulative and continuous duration during which a temperature of the target fuse is greater than or equal to the set temperature. The health state of the target fuse is monitored based on the abnormal operating duration.

It can be understood that the set temperature may be preset based on an application scenario or a specific requirement. For example, the set temperature may be 100°C.

In this embodiment, to determine the abnormal operating duration of the target fuse, the abnormal operating duration can be cleared to zero when the current temperature is less than the set value.

In some embodiments, it can be determined that the health state of the target fuse is abnormal when the abnormal operating duration is greater than or equal to set duration, or it can be determined that the health state of the target fuse is normal when the abnormal operating duration is less than the set duration. The set duration may be preset based on an application scenario or a specific requirement. For example, the set duration may be 20 minutes.

In this embodiment, the health state of the target fuse is monitored based on the abnormal operating duration, which can increase the determining basis of the health state and improve accuracy of the obtained health state data.

In an embodiment of the present disclosure, the method further includes: When the health state of the target fuse is abnormal, a remaining service life of the target fuse is determined based on the proportional coefficient.

In an embodiment, that a remaining service life of the target fuse 2000 is determined based on the proportional coefficient may include: First mapping data reflecting a mapping relationship between the proportional coefficient and the remaining service life is acquired. The remaining service life of the target fuse 2000 is obtained based on the proportional coefficient between the first resistance value and the cold resistance value and the first mapping data.

The first mapping data may be a first mapping function, a first comparison table, or the like, which is not limited herein.

With regard to the first mapping function, a dependent variable of the first mapping function is the remaining service life and an independent variable thereof is the proportional coefficient, so that the remaining service life corresponding to the proportional coefficient can be obtained by substituting the proportional coefficient between the first resistance value and the cold resistance value into the first mapping function.

With regard to the first comparison table, the remaining service life corresponding to the proportional coefficient between the first resistance value and the cold resistance value can be found in the first comparison table. If the proportional coefficient cannot be directly found in the first comparison table, two values adjacent to the proportional coefficient can be found, and the remaining service life corresponding to the proportional coefficient can be obtained by interpolation based on the two values and remaining service lives corresponding to the two values respectively.

In an embodiment, the remaining service life of the target fuse can be predetermined based on a user's driving habits and the proportional coefficient. The remaining service life can be expressed as a number of times that the user can perform extreme working conditions such as rapid acceleration.

In an embodiment of the present disclosure, the method further includes: The health state data of the target fuse is sent to an electronic control unit of the vehicle.

In this embodiment, the health state data of the target fuse may include at least one of the following: a result that the health state of the target fuse is normal or abnormal, the proportional coefficient, the remaining service life, the Joule integral and the first resistance value.

In an example, the electronic control unit may send a life early-warning to a background server or make an abnormality reminder through a dashboard of the vehicle when the health state of the target fuse is abnormal.

In an example, the electronic control unit may send a life pre-warning to the background server when the proportional coefficient is greater than or equal to a second coefficient threshold. The second coefficient threshold may be preset based on an application scenario or a specific requirement. For example, the second coefficient threshold may be 2.

In an example, the electronic control unit can control the dashboard of the vehicle to display the health state data of the target fuse.

In an example, the electronic control unit can determine the remaining service life based on the proportional coefficient and the user's driving habits.

Through this embodiment, the user can be reminded to replace the target fuse in time, so as to prevent the user from driving under extreme working conditions such as rapid acceleration when a target fuse fault occurs, which otherwise affects the user's safety, thereby ensuring the user's driving safety.

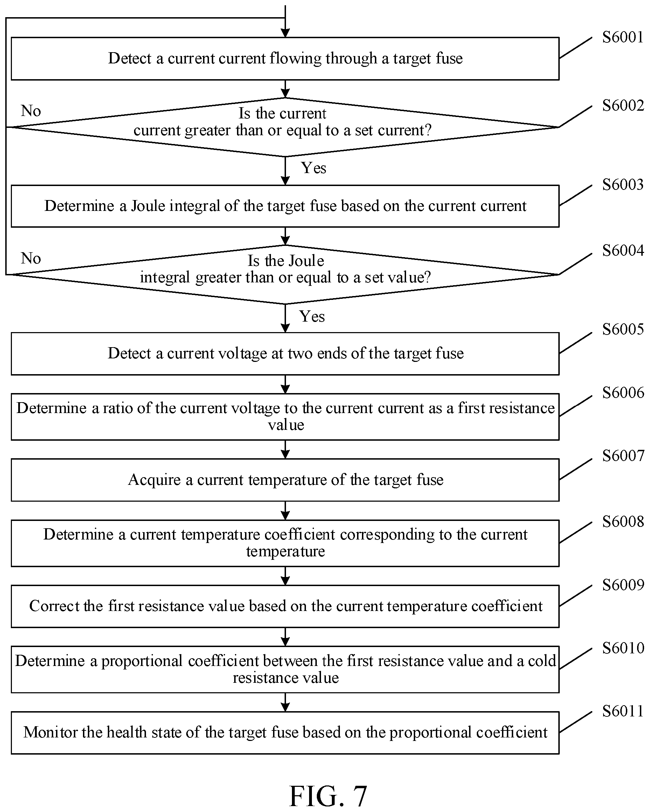

FIG. 7 is a schematic diagram of an example of a fuse monitoring method according to this embodiment.

As shown in FIG. 6, the method may include the following steps S6001 to S6011:
Step S6001: A current current flowing through a target fuse to be monitored is detected.
Step S6002: It is determined whether the current current is greater than or equal to a set current. If so, step S6003 is performed. If not, step S6001 is determined.
Step S6003: A Joule integral of the target fuse is determined based on the current current.
Step S6004: It is determined whether the Joule integral is greater than or equal to a set value. If so, step S6005 is performed. If not, step S6001 is determined.
Step S6005: A current voltage at two ends of the target fuse is detected.
Step S6006: A ratio of the current voltage to the current current is determined as a first resistance value of the target fuse.
Step S6007: A current temperature of the target fuse is acquired.
Step S6008: A temperature coefficient corresponding to the current temperature is determined as a current temperature coefficient.
Step S6009: The first resistance value is corrected based on the current temperature coefficient.
Step S6010: A proportional coefficient between the first resistance value and a cold resistance value is determined.
Step S6011: A health state of the target fuse is monitored based on the proportional coefficient.

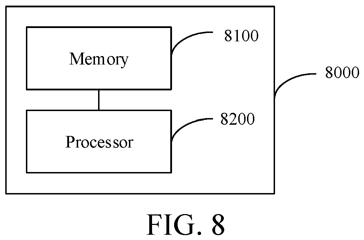

In another aspect, this embodiment provides a fuse monitoring apparatus. As shown in FIG. 8, the fuse monitoring apparatus 8000 includes a memory 8100 and a processor 8200. The memory 8100 is configured to store a computer program, and the processor is configured to perform the fuse monitoring method described in any method embodiment of this specification under the control of the computer program.

This embodiment further provides a vehicle. The vehicle may include the power distribution system 4000 described in the aforementioned embodiment, or may include the fuse monitoring apparatus 8000 described in the aforementioned embodiment.

In an example, the vehicle may further have at least one of other hardware structures such as a processor, a processor engine, a motor controller, an induction apparatus, an input apparatus, an interface apparatus, an output apparatus, a motor and a power battery, which is not limited herein.

A rear end (the end connected to a flywheel) of the engine may be connected to an input end of a speed reducer by a clutch, and an output end of the speed reducer is connected to a wheel axle so as to drive wheels to rotate by the engine.

The motor controller is configured to control the motor to act based on a control instruction sent by the processor, for example, to control the motor to output a torque so as to drive the wheel axle to rotate, and for another example, to control the motor to feed back electric energy to the power battery.

The induction apparatus may include various sensors, and the like, and for example, include at least one of a rotating speed sensor, a posture sensor, a temperature sensor, a humidity sensor, a pressure sensor, and the like.

The input apparatus may include a key circuit, a touchscreen, a microphone, a knob circuit, an accelerator control apparatus with an accelerator pedal, a brake control apparatus with a brake pedal, and the like.

The interface apparatus may include a headset jack, a diagnostic interface of an on-board diagnostics (OBD) system, a charging interface, a universal serial bus (USB) interface, and the like.

The output apparatus may include a display, a speaker, various indicator lights, and the like.

When the motor is used as an electric motor, the power battery may be configured to provide electric energy for the motor.

It should be noted that although the operations of the method according to the present disclosure are described in a specific order in the accompanying drawings, this does not require or imply that these operations need to be performed in the specific order, or that all the illustrated operations need to be performed before a desired result can be achieved. On the contrary, the steps described in the flowcharts may change in execution order. Additionally or alternatively, some steps may be omitted, multiple steps may be combined into one step for execution, and/or one step may be decomposed into multiple steps for execution.

The present disclosure may be a system, a method and/or a computer program product. The computer program product may include a computer-readable storage medium, which carries computer-readable program instructions for causing a processor to implement each of aspects of the present disclosure.

The computer-readable storage medium may be a tangible device that can hold and store instructions used by an instruction execution device. The computer-readable storage medium may be, but is not limited to, an electrical storage device, a magnetic storage device, an optical storage device, an electromagnetic storage device, a semiconductor storage device or any suitable combination thereof. More specific examples (a non-exhaustive list) of computer-readable storage media include: a portable computer disk, a hard disk, a random access memory (RAM), a read-only memory (ROM), an erasable programmable read-only memory (EPROM or flash memory), a static random access memory (SRAM), a portable compact disc read-only memory (CD-ROM), a digital versatile disc (DVD), a memory stick, a floppy disk, a mechanical coding device such as a punched card or an in-groove protruding structure on which instructions are stored, or any suitable combination thereof. The computer-readable storage medium used herein is not to be interpreted as an instantaneous signal itself, such as a radio wave or other freely propagating electromagnetic waves, an electromagnetic wave propagating through a waveguide or other transmission media (for example, an optical pulse through an optical fiber cable) or an electrical signal transmitted through a wire.

The computer-readable program instructions described herein can be downloaded from computer-readable storage media to each computing/processing device, or downloaded to an external computer or external storage device via a network, such as the Internet, a local area network, a wide area network and/or a wireless network. The network may include copper transmission cables, optical fiber transmission, wireless transmission, routers, firewalls, switches, gateway computers and/or edge servers. A network adapter card or network interface in each computing/processing device receives computer-readable program instructions from the network and forwards the computer-readable program instructions for storage on a computer-readable storage medium in each computing/processing device.

The computer program instructions for performing operations of the present disclosure may be assembly instructions, instruction set architecture (ISA) instructions, machine instructions, machine-related instructions, microcode, firmware instructions, state setting data, or source code or object code written in any combination of one or more programming languages. The programming languages include object-oriented programming languages such as Smalltalk and C++, and conventional procedural programming languages such as C language or a similar programming language. The computer-readable program instructions may be completely executed on a user computer, partially executed on a user computer, executed as an independent software package, partially executed on a user computer and partially executed on a remote computer, or completely executed on a remote computer or server. In cases involving a remote computer, the remote computer may be connected to a user computer via any type of network, including a local area network (LAN) or a wide area network (WAN), or may be connected to an external computer (such as via the Internet by an Internet service provider). In some embodiments, state information of computer-readable program instructions is used to perform personalized customization of an electronic circuit, such as a programmable logic circuit, a field programmable gate array (FPGA) or a programmable logic array (PLA). The electronic circuit can execute the computer-readable program instructions, thereby implementing each aspect of the present disclosure.

Each aspect of the present disclosure is described herein with reference to flowcharts and/or block diagrams of the method, the apparatus (system), and the computer program product according to the embodiments of the present disclosure. It should be understood that each block of the flowcharts and/or block diagrams and a combination of blocks in the flowcharts and/or block diagrams can be implemented by computer-readable program instructions.

These computer-readable program instructions can be provided to a processor of a general-purpose computer, special-purpose computer or another programmable data processing apparatus to produce a machine, so that these instructions, when executed by the processor of the computer or another programmable data processing apparatus, produce an apparatus for implementing functions/actions specified in one or more blocks in the flowcharts and/or block diagrams. These computer-readable program instructions may alternatively be stored in a computer-readable storage medium. These instructions cause a computer, a programmable data processing apparatus and/or another device to operate in a specific manner, so that the computer-readable medium storing the instructions includes a manufactured product, which includes instructions for implementing each aspect of the functions/actions specified in one or more blocks in the flowcharts and/or block diagrams.

The computer-readable program instructions may alternatively be loaded onto a computer, another programmable data processing apparatus or another device, so that a series of operational steps are performed on the computer, another programmable data processing apparatus or another device to produce a computer-implemented process, and therefore the instructions executed on the computer, another programmable data processing apparatus or another device implement the functions/actions specified in one or more blocks in the flowcharts and/or block diagrams.

The flowcharts and block diagrams in the accompanying drawings illustrate system architectures, functions and operations of possible implementations of the system, the method and the computer program product according to multiple embodiments of the present disclosure. In this regard, each block in the flowcharts or block diagrams may represent a module, a program segment or part of instructions, and the module, the program segment or the part of instructions include one or more executable instructions for implementing a specified logic function. In some alternative implementations, the functions marked in the blocks may alternatively occur in a different order from that marked in the accompanying drawings. For example, two consecutive blocks may actually be executed substantially in parallel, or sometimes may be executed in the reverse order, depending on a function involved. It should be also noted that each block in the block diagrams and/or the flowcharts and a combination of blocks in the block diagrams and/or the flowcharts may be implemented by a dedicated hardware-based system that performs specified functions or actions, or may be implemented by a combination of dedicated hardware and computer instructions. It is well known to a person skilled in the art that it is equivalent to implement by hardware, software and a combination of software and hardware.

Embodiments of the present disclosure have been described above, and the above descriptions are illustrative, not exhaustive, and are not limited to the disclosed embodiments. Many modifications and changes are clear to a person of ordinary skill in the art without departing from the scope and spirit of the illustrated embodiments. The terms used herein are chosen to best explain the principles of the embodiments, practical applications or technical improvements in the market, or to enable other persons of ordinary skill in the art to understand the embodiments disclosed herein. The scope of the present disclosure is defined by the appended claims.

## Claims

1. A fuse monitoring system, comprising:
a current detection unit, the current detection unit being configured to detect a current current flowing through a target fuse;
a voltage detection unit, the voltage detection unit being connected to the target fuse, and the voltage detection unit being configured to detect a current voltage at two ends of the target fuse; and
an integrated control unit, the integrated control unit being connected to the current detection unit and the voltage detection unit, and the integrated control unit being configured to determine a health state of the target fuse based on the current current and the current voltage.

2. The fuse monitoring system according to claim 1, wherein the current detection unit comprises:
a shunt, the shunt being connected to a power supply loop of the target fuse; and
a first optocoupler isolation and conditioning unit, an input end of the first optocoupler isolation and conditioning unit being connected to two ends of the shunt, and an output end of the first optocoupler isolation and conditioning unit being connected to the integrated control unit.

3. The fuse monitoring system according to claim 1, further comprising:
a temperature detection unit, the temperature detection unit being arranged in a first preset range close to the target fuse and being connected to the integrated control unit.

4. The fuse monitoring system according to claim 1, further comprising:
a communication unit, the communication unit being connected to the integrated control unit and being suitable for connection to an electronic control unit of a vehicle; and
the communication unit being configured to acquire health state data of the target fuse sent by the integrated control unit and send the health state data to the electronic control unit.

5. The fuse monitoring system according to claim 1, wherein the voltage detection unit comprises a second optocoupler isolation and conditioning unit, and
an input end of the second optocoupler isolation and conditioning unit is connected to the two ends of the target fuse, and an output end of the second optocoupler isolation and conditioning unit is connected to the integrated control unit.

6. The fuse monitoring system according to claim 1, wherein the current detection unit further comprises:
a Hall current sensor, the Hall current sensor being arranged in a second preset range close to the target fuse; and
a third optocoupler isolation and conditioning unit, an input end of the third optocoupler isolation and conditioning unit being connected to the Hall current sensor, and an output end of the third optocoupler isolation and conditioning unit being connected to the integrated control unit.

7. A fuse monitoring method, comprising:
detecting a current current flowing through a target fuse to be monitored and a current voltage at two ends of the target fuse; and
determining a health state of the target fuse based on the current current and the current voltage.

8. The method according to claim 7, wherein determining the health state of the target fuse based on the current current and the current voltage specifically comprises:
determining a first resistance value of the target fuse based on the current current and the current voltage; and
determining the health state of the target fuse based on the first resistance value.

9. The method according to claim 8, after determining the first resistance value of the target fuse, the method further comprising:
acquiring a current temperature of the target fuse;
determining a temperature coefficient corresponding to the current temperature as a current temperature coefficient; and
correcting the first resistance value based on the current temperature coefficient.

10. The method according to claim 8, wherein determining the health state of the target fuse based on the first resistance value comprises:
acquiring a second resistance value of the target fuse, the second resistance value representing a cold resistance value of the target fuse;
determining a proportional coefficient between the first resistance value and the second resistance value; and
determining the health state of the target fuse based on the proportional coefficient.

11. The method according to claim 10, further comprising:
determining a remaining service life of the target fuse based on the proportional coefficient when the proportional coefficient is greater than or equal to a first coefficient threshold,
preferably wherein determining the remaining service life of the target fuse based on the proportional coefficient comprises:
acquiring first mapping data reflecting a mapping relationship between the proportional coefficient and the remaining service life; and
obtaining the remaining service life of the target fuse based on the proportional coefficient between the first resistance value and the second resistance value and the first mapping data.

12. The method according to claim 7, further comprising:
determining a Joule integral of the target fuse based on the current current when the current current is greater than or equal to a set current; and
performing, when the Joule integral is greater than or equal to a set value, the step of determining a health state of the target fuse based on the current current and the current voltage;
or further comprising:
acquiring a current temperature of the target fuse;
determining an abnormal operating duration of the target fuse when the current temperature is greater than or equal to a set temperature, the abnormal operating duration being cumulative and continuous duration during which a temperature of the target fuse is greater than or equal to the set temperature; and
monitoring the health state of the target fuse based on the abnormal operating duration.

13. A fuse monitoring apparatus, comprising a memory and a processor, the memory being configured to store a computer program, and the processor being configured to perform the method according to any one of claims 7 to 12 under the control of the computer program.

14. A power distribution system, comprising a fuse and the fuse monitoring system according to any one of claims 1 to 6.

15. A vehicle, comprising the power distribution system according to claim 14 or the fuse monitoring apparatus according to claim 13.
